# EUROPÄISCHE PATENTSCHRIFT

(11) **EP 0 261 371 B1**
(45) Veröffentlichungstag und Bekanntmachung des Hinweises auf die Patenterteilung: **10.03.1993**
(21) Anmeldenummer: 87111573.9
(22) Anmeldetag: 10.08.1987
(51) Int. Cl.: H01L 27/04

(54) **Integrierte Schaltung mit "Latch-up" Schutzschaltung in komplementärer MOS Schaltungstechnik**
Integrated circuit with latch-up protection circuit fabricated by complementary MOS technology
Circuit intégré ayant un circuit anti virrouillage fabriqué en technologie MOS complémentaire

(30) Priorität: 26.09.1986 DE 3632844
(43) Veröffentlichungstag der Anmeldung: 30.03.1988
(73) Patentinhaber: SIEMENS AKTIENGESELLSCHAFT, 80333 München (DE)
(72) Erfinder: Winnerl, Josef, Dr., D-8300 Landshut (DE); Reczek, Werner, D-8000 München 90 (DE); Pribyl, Wolfgang, Dr., A-9500 Villach (DE)

(56) Entgegenhaltungen:
- EP-A- 0 142 258
- EP-A- 0 175 152
- GB-A- 2 103 897
- US-A- 4 303 958
- US-A- 4 353 105
- IEEE, 1985, Seiten 504-508, New York, US; D. TACKACS et al.: "Static and transient latch-up hardness in N-Well CMOS with on-chip substrate bixs generator"

## Beschreibung

Die Erfindung bezieht sich auf eine integrierte Schaltung mit "Latch-up" Schutzschaltung in komplementärer MOS Schaltungstechnik nach den gleichlautenden Oberbegriffen der Patentansprüche 1 und 10.

Bei integrierten Schaltungen dieser Art in komplementärer MOS-Technologie liegt das Halbleitersubstrat nicht auf dem Massepotential der integrierten Schaltung, sondern es wird durch einen Substratvorspannungsgenerator aufgeladen. Die Substratvorspannung des Substratvorspannungsgenerators verringert die Transistor- und Sperrschichtkapazitäten und verbessert die Schaltgeschwindigkeit. Bei einem Halbleitersubstrat aus p-leitendem Material, das mit einer eingefügten n-leitenden wannenförmigen Halbleiterzone versehen ist, handelt es sich dabei um eine negative Substratvorspannung von etwa -2 bis -3 Volt. Die Sourcegebiete von Feldeffekttransistoren, die außerhalb der wannenförmigen Halbleiterzone auf dem Halbleitersubstrat vorgesehen sind, sind hierbei auf das Massepotential gelegt.

Im Moment des Einschaltens der positiven Versorgungsspannung befindet sich das betrachtete p-leitende Halbleitersubstrat zunächst in einem Zustand des "floating", in dem es von äußeren Potentialen freigeschaltet ist.

Dieser Zustand wird durch das Wirksamwerden des Substratvorspannungsgenerators beendet. Die Zeitspanne zwischen dem Einschalten der Versorgungsspannung und dem Wirksamwerden des Substratvorspannungsgenerators wird im wesentlichen durch die Taktfrequenz, vorhandene Koppelkapazitäten und die vorhandene kapazitive Last beeinflußt. In der Zeit des "floating" kann das Halbleitersubstrat über die Sperrschichtkapazitäten, die einerseits zwischen der wannenförmigen Halbleiterzone und dem Substrat und andererseits zwischen den mit dem Massepotential belegten Sourcegebieten und dem Substrat vorhanden sind, vorübergehend auf eine positive Vorspannung aufgeladen werden, die erst beim Wirksamwerden des Substratvorspannungsgenerators wieder abgebaut und durch die sich am Ausgang desselben allmählich aufbauende negative Substratvorspannung ersetzt wird. Aber auch im Betrieb der integrierten Schaltung können größere Ströme, die vom Halbleitersubstrat über den Substratvorspannungsgenerator zu einem auf Massepotential liegenden Anschluß des letzteren abgeleitet werden, durch den Spannungsabfall am Innenwiderstand des Substratvorspannungsgenerators zu einer positiven Vorspannung des Halbleitersubstrats führen. Positive Vorspannungen stellen aber ein hohes Sicherheitsrisiko für die integrierte Schaltung dar, da ein "Latch-up"-Effekt ausgelöst werden kann, der im allgemeinen den Ausfall der integrierten Schaltung bedeutet.

Zum Verständnis des "Latch-up"-Effekts kann man davon ausgehen, daß zwischen einem Anschluß eines in der wannenförmigen Halbleiterzone liegenden Feldeffekttransistors des ersten Kanaltyps und einem Anschluß eines außerhalb dieser Zone auf dem Halbleitersubstrat plazierten Feldeffekttransistor des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzten Transistors die vierte Halbleiterschicht bilden. Aufgrund dieses Aufbaus gibt ergeben sich ein parasitärer bipolarer pnp- und ein npn-Transistor. Der Kollektor des pnp-Transistors entspricht der Basis des npn-Transistors und die Basis des pnp-Transistors dem Kollektor des npn-Transistors. Diese Struktur bildet eine Vierschichtdiode pnpn wie bei einem Thyristor. Bei einer positiven Vorspannung des Halbleitersubstrats kann der pn-Übergang zwischen der dritten und vierten Halbleiterschicht soweit in Durchlaßrichtung vorgespannt werden, daß zwischen den genannten Transistoranschlüssen ein Strompfad entsteht, der auf eine parasitäre Thyristorwirkung innerhalb dieser Vierschichtenstruktur zurückzuführen ist. Der Strompfad bleibt dann auch nach einem Abbau der positiven Substratvorspannung bestehen und kann die integrierte Schaltung thermisch überlasten.

Es ist bekannt, daß zur Verringerung der Transistor- und Sperrschichtkapazitäten eine negative Substratvorspannung in der NMOS-Technik verwendet wird, die über einen sogenannten Substratvorspannungsgenerator auf der integrierten Schaltung erzeugt wird (siehe Buchreihe Halbleiterelektronik, 14, H. Weiß, K. Horninger "Integrierte MOS-Schaltungen", Seiten 247 bis 248). Der "Latch-up"-Effekt bei positiven Halbleitersubstratspannungen ist ebenfalls in diesem Fachbuch auf den Seiten 111 bis 112 beschrieben. Als Abhilfe werden hier eine Änderung der Technologie (Dotierungsprofile) oder Maßnahmen beim Entwurf (Wannenabstände) vorgeschlagen.

Aus der Veröffentlichung D. Takacs et al., "Static and transient latch-up hardness in n-well CMOS with on-chip substrate bias generator", IEDM 85, Technical Digest, Seite 504 bis 508 und aus der europäischen Anmeldeschrift EP-A-0 142 258 ist eine integrierte Schaltung in komplementärer Schaltungstechnik mit Feldeffekttransistoren unterschiedlicher Kanaltypen, von denen wenigstens ein erster in einem p-leitenden Halbleitersubstrat und wenigstens ein zweiter in einer im Halbleitersubstrat vorgesehenen n-leitenden wannenförmigen Halbleiterzone angeordnet sind, wobei die Halbleiterzone mit einer positiven Versorgungsspannung beschaltet ist, wobei ein Anschlußgebiet wenigstens eines ersten Feldeffekttransistors mit einem Massepotential angeschlossen ist, wobei das Halbleitersubstrat mit dem Ausgang eines eine negative Substratvorspannung erzeugenden Substratvorspannungsgenerators verbunden ist, dem das Massepotential und die Versorgungsspannung zugeführt werden, wobei der Ausgang des Substratvorspannungsgenerators über einen dritten, n-Kanal-Feldeffekttransistor mit einem auf Massepotential liegenden Schaltungspunkt verbunden ist, und wobei der Gateanschluß des dritten Feldeffekttransistors mit dem Substratvorspannungsanschluß verbunden ist, bekannt.

Es wird hierin eine Klemmschaltung vorgeschlagen, die einen "Latch-up"-Effekt dadurch verhindert, indem das Halbleitersubstratpotential auf einen Wert begrenzt wird, der nicht ausreicht, die parasitären Bipolartransistoren im Halbleitersubstrat zu aktivieren. Die Klemmschaltung muß dazu die hohen kapazitiven Ladedeströme nach Masse abführen.

Durch die oben angegebene Klemmschaltung wird prinzipiell nicht die Möglichkeit der positiven Aufladung des Halbleitersubstrats ausgeschlossen, sondern es werden lediglich seine Auswirkungen dadurch kompensiert, daß, falls eine positive Aufladung des Halbleitersubstrats erfolgt ist, eine niederohmige Masseverbindung die positive Aufladung wieder abbaut.

Der Erfindung liegt die Aufgabe zugrunde, eine Schaltung der eingangs genannten Art anzugeben, bei der das Auftreten von "Latch-up"-Effekten weitgehend vermieden wird. Das wird erfindungsgemäß durch eine Ausbildung der Schaltung nach dem kennzeichnenden Teil des Patentanspruchs 1 oder 10 erreicht.

Die Patentansprüche 2 bis 9 und 11 bis 18 sind auf bevorzugte Ausgestaltungen und Weiterbildungen der Erfindung gerichtet. Der Patentanspruch 19 betrifft eine bevorzugte Anwendung der Erfindung.

Der mit der Erfindung erzielbare Vorteil liegt insbesondere darin, daß eine unerwünscht hohe Aufladung des Halbleitersubstrats, die einen "Latch-up"-Effekt auslösen kann, mit einfachen Mitteln auf einen Wert begrenzt wird, der diese Gefahr ausschließt.

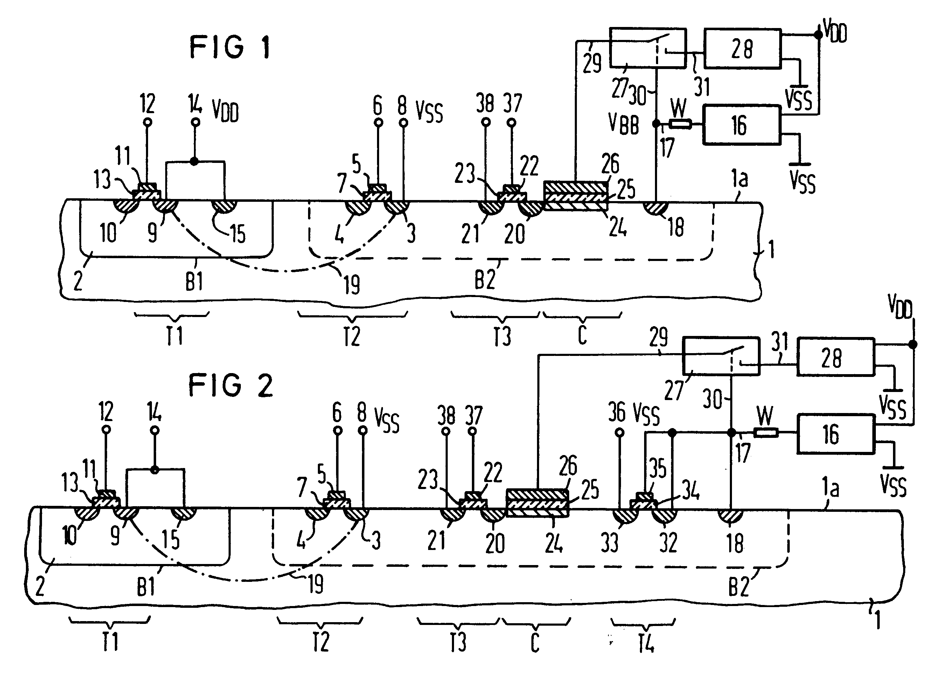

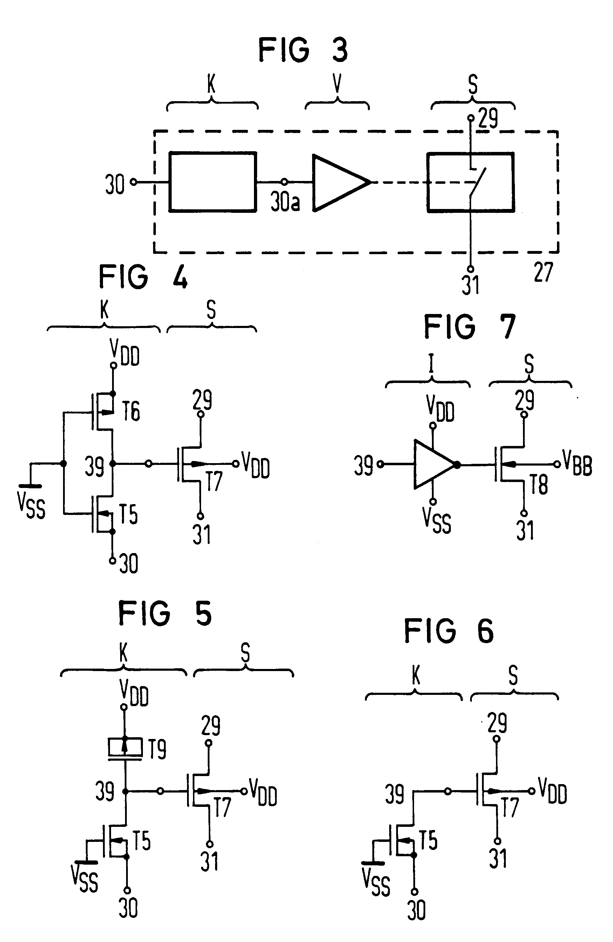

Zwei Ausführungsbeispiele der Erfindung sind in den Zeichnungen in Figur 1 und 2 dargestellt und werden im folgenden näher beschrieben. Es zeigt
- Figur 1: eine integrierte Schaltung mit "Latch-up" Schutzschaltung in CMOS Schaltungstechnik mit einer Eintransistorspeicherzelle,
- Figur 2: eine integrierte Schaltung mit "Latch-up" Schutzschaltung wie Figur 1, zusätzlich ausgestattet mit einer Klemmschaltung,
- Figur 3: eine Prinzipschaltung einer "Latch-up" Schutzschaltung,
- Figur 4: ein Ausführungsbeispiel für eine "Latch-up" Schutzschaltung mit ohm'scher Last,
- Figur 5, 6: Ausführungsbeispiele für "Latch-up" Schutzschaltungen mit kapazitiver Last,
- Figur 7: ein Ausführungsbeispiel für den elektronischen Schalter (S) in einer "Latch-up" Schutzschaltung.

In Figur 1 ist eine erfindungsgemäße integrierte Schaltung mit "Latch-up" Schutzschaltung dargestellt, die auf einem Halbleitersubstrat 1 aus dotiertem Halbleitermaterial, zum Beispiel p-leitendem Silizium, aufgebaut ist. Das Halbleitersubstrat 1 weist eine n-leitende, wannenförmige Halbleiterzone 2 auf, die sich bis zur Grenzfläche 1a des Halbleitersubstrats 1 hin erstreckt. Außerhalb der Halbleiterzone 2 sind in das Halbleitersubstrat n⁺-dotierte Halbleitergebiete 3, 4, 20 und 21 eingefügt, die die Source- und Draingebiete zweier n-Kanal-Feldeffekttransistoren T2 und T3 bilden. Der Kondensator C, der beliebig ausgebildet sein kann, besteht in diesem Fall aus einer planaren Dielektrikumschicht 25, einer planaren Polysiliziumschicht 26 und einer n-dotierten Schicht 24 und bildet zusammen mit dem n-Kanal-Feldeffekttransistor T3 eine Eintransistorspeicherzelle, in die Informationen abgelegt oder aus der Informationen ausgelesen werden können. Der zwischen 3 und 4 bzw. 20 und 21 liegende Kanalbereich wird von einem Gate 5 bzw. 22 überdeckt, das mit einem Anschluß 6 bzw. 37 versehen ist und durch eine dünne elektrisch isolierende Schicht 7 bzw. 23, z.B. aus SiO₂, von der Grenzfläche 1a getrennt ist. Das Draingebiet 21 ist mit dem Anschluß 38 verbunden, während das Sourcegebiet 3 mit dem auf Massepotential V_{SS} liegenden Anschluß 8 verschaltet ist. Weiterhin sind in die Halbleiterzone 2 p⁺-dotierte Gebiete 9 und 10 eingefügt, welche das Source- und das Draingebiet eines p-Kanal-Feldeffekttransistors T1 darstellen. Der zwischen den Gebieten 9 und 10 liegende Kanalbereich wird von einem Gate 11 überdeckt, das mit einem Anschluß 12 versehen ist und durch eine dünne elektrisch isolierende Schicht 13, zum Beispiel aus SiO₂, von der Grenzfläche 1a getrennt ist. Das Sourcegebiet 9 vom Feldeffekttransistor T1 ist mit einem Anschluß 14 verbunden, der mit einem Versorgungspotential V_{DD} beschaltet ist. Über ein n⁺-dotiertes Kontaktgebiet 15, das mit dem Anschluß 14 in Verbindung steht, liegt die Halbleiterzone 2 auf der Versorgungsspannung V_{DD}.

Weiterhin ist ein Substratvorspannungsgenerator 16 vorgesehen, der eine negative Substratvorspannung von zum Beispiel -2 bis -3 Volt erzeugt und seinerseits an Masse V_{SS} und an die Versorgungsspannung V_{DD} angeschlossen ist. Der Ausgang 17 des Substratvorspannungsgenerators ist über den Eingang 30 mit der Latch-up-Schutzschaltung 27 und mit einem p⁺-dotierten Substratspannungsanschluß 18 verbunden, der in das Halbleitersubstrat 1 eingefügt ist. Damit befindet sich das Halbleitersubstrat 1 auf der durch 16 erzeugten negativen Substratvorspannung V_{BB}, während sich die Sourcegebiete, zum Beispiel 3, der im Halbleitersubstrat 1 befindlichen Transistoren, zum Beispiel T2, auf Massepotential V_{SS} befinden. Hierdurch wird unter anderem erreicht, daß die Sperrschichtkapazitäten der Drain- und Sourcegebiete der im Halbleitersubstrat 1 angeordneten Transistoren verkleinert werden. Zur Vermeidung eines " Latch-up"-Effekts, der entlang der gestrichelten Linie 19 liegenden Vierschichtstruktur 3, 1, 2 und 9 zwischen den Anschlüssen 8 und 14 auftreten könnte, werden die kapazitiven Ladeströme des Kondensators C durch die elektronische Schutzschaltung 27 auf Werte vermindert, die nicht ausreichen, das Substrat soweit positiv aufzuladen, daß ein "Latch-up" ausgelöst wird. In der elektronischen Schutzschaltung 27 wird in Abhängigkeit von einer Signalgröße am Eingang 30 der Eingang 31 elektrisch mit dem Ausgang 29, der an einer Kondensatorfläche 26 des Kondensators C angeschlossen ist, verbunden. Der Eingang 31 ist an einen Vorspannungsgenerator 28 für den Kondensator angeschlossen, der seinerseits mit Masse V_{SS} und mit der Versorgungsspannung V_{DD} verbunden ist. Die Ausgangsspannung des Vorspannungsgenerators kann beispielsweise die Hälfte der Versorgungsspannung, also V_{DD}/2 betragen. Der Eingang 30 der elektronischen Schutzschaltung ist gleichzeitig mit dem Ausgang 17 des Substratvorspannungsgenerators 16 und mit dem p⁺-dotierten Substratvorspannungsanschluß 18 verbunden. Beim Einschalten der integrierten Schaltung und bei Spannungen V_{BB}, die größer sind als eine interne Referenspannung bewirkt die elektronische Schutzschaltung eine Unterbrechung zwischen dem Eingang 31 und dem Ausgang 29. Dies bedeutet, daß bei positivem Substratpotential die kapazitiven Ladeströme vom Vorspannungsgenerator 28 auf den Kondensator C unterbunden werden. Dies tritt beispielsweise dann ein, wenn beim Einschalten der Versorgungsspannung V_{DD} das Halbleitersubstrat 1 durch die kapazitiven Ladeströme auf eine positive Vorspannung angehoben wird, solange der Substratvorspannungsgenerator 16 noch nicht seine volle negative Vorspannung liefert. Im Normalbetrieb bzw. bei negativer Substratvorspannung liegt die Kondensatorfläche 26 niederohmig über die elektronische Schutzschaltung 27 am Vorspannungsgenerator 28 für den Kondensator.

In Figur 2 ist ein zweites Ausführungsbeispiel der Erfindung dargestellt, das sich von Figur 1 durch eine zusätzliche Klemmschaltung unterscheidet. Der Ausgang 17 des Substratvorspannungsgenerators 16 ist hierzu über einen elektronischen Schalter, hier ein Feldeffekttransistor T4, mit einem Schaltungspunkt verbunden, der sich auf Massepotential V_{SS} befindet. Beim dargestellten Ausführungsbeispiel handelt es sich bei diesem Schaltungspunkt um den Anschluß 36. Im einzelnen ist der Ausgang bei der Anordnung nach Fig.2 mit einem n⁺-dotierten Halbleitergebiet 32 verbunden, das in das Halbleitersubstrat 1 eingefügt ist. Ein weiteres n⁺-dotiertes, in das Halbleitersubstrat 1 eingefügtes Halbleitergebiet 33 ist mit dem auf Massepotential V_{SS} liegenden Schaltungspunkt, das heißt mit dem Anschluß 36 verbunden. Der zwischen den Gebieten 32 und 33 liegende Bereich des Halbleitersubstrats 1 ist von einem Gate 35 überdeckt, das durch eine dünne elektrisch isolierende Schicht 34, zum Beispiel aus SiO₂, von der Grenzfläche 1a getrennt ist. Die Gebiete 32 und 33 bilden zusammen mit den Teilen 34 und 35 einen n-Kanal-Feldeffektschalttransistor T4. Die Ansteuerung von T4 erfolgt über den Knoten 17.

Der Schalttransistor 32 bis 35 in Figur 2 soll eine niedrige Einsatzspannung haben, die kleiner ist als die Durchlaßspannung des pn-Übergangs zwischen 1 und 3. Das ist in der herkömmlichen Weise zum Beispiel dadurch zu erreichen, daß der zwischen den Gebieten 32 und 33 liegende Bereich des Halbleitersubstrats 1 außer der Grunddotierung, die zum Beispiel 10¹⁵cm⁻³ beträgt, keine zusätzliche Dotierung aufweist, während die Kanalbereiche der übrigen Feldeffekttransistoren, zum Beispiel T2, in der Nähe der Grenzfläche 1a mit einer zusätzlichen, die Grunddotierung verstärkenden Dotierung versehen sind, die zweckmäßigerweise im Wege einer Implantation mit einer Dosis von etwa 10¹²cm⁻² eingebracht wird. Sind in der verwendeten Herstellungstechnik zwei verschiedene Isolierschichtdicken verfügbar, so wird für 34 zweckmäßigerweise die kleinere verwendet, die zum Beispiel 15 nm beträgt, während für die Schicht 7 und 13 eine Dicke von etwa 20 bis 25 nm gewählt wird. Liegt das Halbleitersubstrat 1 auf einer positiven Vorspannung, was beispielsweise beim Anschalten der Versorgungsspannung V_{DD} auftritt, wenn der Substratvorspannungsgenerator 16 noch nicht die volle negative Spannung hat, wie dies in Figur 1 schon erläutert wurde, so ist auch das Gate 35 entsprechend positiv vorgespannt, was bei Überschreiten der niedrigen Einsatzspannung dazu führt, daß der Schalttransistor 32 bis 35 leitet. Damit wird dann die Spannung am Knoten 17 auf den Wert der niedrigen Einsatzspannung begrenzt.

Während die elektronische Schutzschaltung durch eine Unterbrechung des kapazitiven Ladestromes des Kondensators C eine positive Aufladung durch diesen Ladestrom am Halbleitersubstrat 1 verhindert, wirkt die zusätzliche Klemmschaltung allen übrigen Möglichkeiten der positiven Substrataufladung entgegen. Ergeben sich beispielsweise im Betrieb große Ströme, die über das Halbleitersubstrat 1 und die Teile 18, 17, 16 nach Masse V_{SS} abfließen, so kann am Innenwiderstand W von 16 ein solcher Spannungsabfall entstehen, daß der Ausgang 17 und damit das Halbleitersubstrat 1 zumindest vorübergehend auf eine positive Vorspannung gelangt. In diesem Falle werden diese Ströme über die zusätzliche Klemmschaltung abgeführt.

Der Substratvorspannungsgenerator 16, die elektronische Schutzschaltung 27 sowie der Vorspannungsgenerator 28 für den Kondensator der Figuren 1 und 2 sind zweckmäßigerweise auf dem Halbleitersubstrat mit aufintegriert.

In Figur 3 ist eine Prinzipschaltung der elektronischen Schutzschaltung 27 angegeben. Sie besteht aus drei Einzelkomponenten, einem Komparator K mit einem Eingang 30, einem Verstärker V und einem elektronischen Schalter S mit einem Eingang 31 und einem Ausgang 29. Der Komparator vergleicht die am Eingang 30 anliegende Spannung mit einem intern vorgegebenen Spannungswert bzw. dem Massepotential V_{SS} . Fällt der Vergleich positiv aus, dies bedeutet, die anliegende Spannung ist größer als der interne Spannungswert, wird ein entsprechendes Signal an den Ausgang 30a abgegeben, das über den Verstärker V verstärkt wird und in dem elektronischen Schalter S den Eingang 31 und Ausgang 29 elektrisch voneinander trennt. Ist die anliegende Spannung am Eingang 30 jedoch kleiner als der interne Spannungswert, werden über ein zweites Signal am Ausgang 30 der Eingang 31 und der Ausgang 29 im elektronischen Schalter S elektrisch miteinander verbunden. Der Verstärker V ist wahlweise einzubauen, je nach der erforderlichen Anpassung des Ausgangssignals des Komparators K an den elektronischen Schalter S.

Ein Ausführungsbeispiel für eine elektronische Schutzschaltung 27 mit ohm'scher Last ist in Figur 4 dargestellt. Sie besteht lediglich aus zwei Komponenten, einem Komparator K und einem elektronischen Schalter S. Für den Komparator K ist eine Serienschaltung eines n-Kanal-Feldeffekttransistors T5 und eines ohm'schen Lastelements vorgesehen, das insbesondere durch einen p-Kanal-Feldeffekttransistor T6 gebildet wird, dessen Substrat mit seinem Sourceanschluß verbunden ist. Die Gates der Feldeffekttransistoren T5 und T6 sind zusammengeschaltet und mit der Masse V_{SS} verbunden. Der eine Anschluß der Serienschaltung ist auf die Versorgungsspannung V_{DD} gelegt, während der andere Anschluß und der Substratanschluß des Feldeffekttransistors T5 den Eingang 30 der elektronischen Schutzschaltung 27 bilden. Der elektronische Schalter S ist durch einen p-Kanal-Feldeffekttransistor T7 realisiert. Source- und Drainanschluß bilden jeweils den Eingang 31 und den Ausgang 29 der elektronischen Schutzschaltung 27. Der Verbindungspunkt 39 ist an das Gate des p-Kanal-Feldeffekttransistors T7 angeschlossen, während der Substratanschluß des Feldeffekttransistors T7 auf die Versorgungsspannug V_{DD} gelegt ist.

Übersteigt beim Einschalten oder im Betrieb die Spannung am Eingang 30 die Spannung V_{SS} (Masse)- UT (Einsatzspannung des Feldeffekttransistors T5), so steigt die Ausgangsspannung des Komparators K am Verbindungspunkt 39. Der Feldeffekttransistor T5 sperrt und der Verbindungspunkt 39 liegt über das Lastelement, in diesem Fall den p-Kanal-Feldeffekttransistor T6 an der Versorgungsspannung V_{DD} . Aus diesem Grund sperrt der p-Kanal-Feldeffekttransistor T7 und die Verbindung zwischen dem Eingang 31 und dem Ausgang 29 ist unterbrochen. Bei einer Substratvorspannung am Eingang 30, die kleiner als V_{SS} -U_{T} ist leiten die Feldeffekttransistoren T5 und T7, so daß der Eingang 31 und der Ausgang 29 elektrisch miteinander verbunden sind. Im Betrieb wird durch die Feldeffekttransistoren T5 und T6 ein entsprechend ihrer Dimensionierung kleiner Querstrom fließen.

Zwei Ausführungsbeispiele für eine elektronische Schutzschaltung 27 mit kapazitiver Last zeigen die Figuren 5 und 6. Sie bestehen ebenfalls aus je zwei Komponenten, einem Komparator K und einem elektronischen Schalter S. Die kapazitive Last kann wie in Figur 5 durch einen als Kondensator geschalteten p-Kanal-Feldeffekttransistor T9 realisiert werden oder durch eine ausreichende Dimensionierung der Gatekapazität des p-Kanal-Feldeffekttransistors T7 wie in Figur 6. Die elektronische Schutzschaltung 27 aus Figur 5 und 6 unterscheidet sich von der aus Figur 4 lediglich durch ihr kapazitives Lastelement. Der hierfür in Figur 5 eingesetzte p-Kanal-Feldeffekttransistor T9 wird mit seinem Source-, Drain- und Substratanschluß gegen die Versorgungsspannung V_{DD} geschaltet. Im Ausführungsbeispiel von Figur 6 entfällt der Feldeffekttransistor T9 und der Kondensator wird durch eine ausreichende Dimensionierung der Gatekapazität des Feldeffekttransistors T7 realisiert.

Übersteigt die Spannung am Eingang 30 in Figur 5 und 6 die Spannung V_{SS}-U_{T}, so sperrt der n-Kanal-Feldeffekttransistor T5. Der Verbindungspunkt 39 liegt dabei über den ungeladenen Kondensator auf der Versorgungsspannung V_{DD}, der Feldeffekttransistor T7 sperrt und unterbricht die Verbindung zwischen dem Eingang 31 und Ausgang 29. Unterschreitet die Spannung am Eingang 30 die Spannung V_{SS}-U_{T} so leitet der Feldeffekttransistor T5 und lädt den Kondensator auf. Der Feldeffekttransistor T7 leitet ebenfalls und die Verbindung zwischen dem Eingang 31 und Ausgang 29 ist geschlossen. Im Betriebsfalle sind der Kondensator in Figur 5 und die Gatekapazität in Figur 6 aufgeladen, was dazu führt, daß die elektronischen Schutzschaltungen, im Gegenssatz zu der in Figur 4, querstromfrei sind.

Die elektronischen Schalter S in den Figuren 4, 5 und 6 waren ausschließlich durch p-Kanal-Feldeffekttransistoren realisiert. In Figur 7 ist eine Möglichkeit angegeben den elektronischen Schalter S durch einen n-Kanal-Feldeffekttransistor zu ersetzen. Dies kann beispielsweise notwendig sein, wenn ein elektronischer Schalter S mit höherer Stromergiebigkeit gefordert wird. Zu diesem Zweck ist dem n-Kanal-Feldeffekttransistor T8 ein Inverter I vorgeschaltet. Der Substratanschluß von T8 ist an die Substratvorspannung V_{BB} angeschlossen. Source-und Drain-Anschluß bilden wiederum einen Ein- und Ausgang 31 und 29. Der Inverter I ist mit der Versorgungsspannung V_{DD} und der Masse, sein Eingang mit dem Verbindungspunkt 39 verbunden.

Neben den oben behandelten Ausführungsformen umfaßt die Erfindung auch solche, bei denen n-leitendes Substrat mit p-leitenden wannenförmigen Halbleiterzonen versehen ist. Dabei werden die Leitungstypen sämtlicher Halbleiterteile und die Polaritäten sämtlicher Spannungen durch die jeweils entgegengesetzten ersetzt.

Weiterhin werden auch solche Ausführungsformen von der Erfindung erfaßt, die sich aus Figur 1 und Figur 2 durch folgende Abänderungen ergeben. Die Begrenzungslinie B1 fällt weg, wobei diese beiden Teile nunmehr als n-leitendes Substrat aufzufassen sind. Hiervon ausgehend wird dann in dieses n-leitende Substrat eine p-leitende wannenförmige Halbleiterzone eingefügt, die durch die gestrichelte Linie B2 gegen das n-leitende Substrat abgegrenzt ist und die Schaltungsteile T2, T3, C, T4 und 18 enthält.

Eine bevorzugte Anwendung der Erfindung ergibt sich für die Peripherieschaltungen von dynamischen Halbleiterspeichern großer Packungsdichte, die mit den Speicherzellen monolithisch integriert sind.

## Patentansprüche

1. Integrierte Schaltung in komplementärer Schaltungstechnik mit Feldeffekttransistoren (T1, T2) unterschiedlicher Kanaltypen, von denen wenigstens ein erster (T1) in einem p-leitenden Halbleitersubstrat (1) und wenigstens ein zweiter (T2) in einer im Halbleitersubstrat vorgesehenen n-leitenden wannenförmigen Halbleiterzone (2) angeordnet sind, wobei die Halbleiterzone (2) mit einer positiven Versorgungsspannung (V_{DD}) beschaltet ist, wobei ein Anschlußgebiet (3) wenigstens eines ersten Feldeffekttransistors (T1) mit einem Massepotential (V_{SS}) angeschlossen ist, wobei das Halbleitersubstrat (1) über einen Substratvorspannungsanschluß (18) mit dem Ausgang 17 eines eine negative Substratvorspannung erzeugenden Substratvorspannungsgenerators (16) verbunden ist, dem das Massepotential und die Versorgungsspannung zugeführt werden, **dadurch gekennzeichnet,** daß ein Kondensator (C) mit zwei Kondensatorflächen (24, 26) vorgesehen ist, dessen erste Kondensatorfläche (24) in dem Halbleitersubstrat (1) integriert ist und dessen zweite Kondensatorfläche (26) über eine elektronische Schutzschaltung (27) an einen Vorspannungsgenerator (28) für den Kondensator geschaltet wird, daß die Schutzschaltung eine Serienschaltung eines Lastelements und eines dritten, n-Kanal Feldeffekttransistors (T5) enthält, daß ein erster Anschluß dieser Serienschaltung, der zugleich einen Anschluß des Lastelements darstellt, mit der Versorgungsspannung (V_{DD}) beschaltet ist, daß der zweite Anschluß dieser Serienschaltung, der zugleich einen Anschluß des dritten Feldeffekttransistors (T5) und einen Substratanschluß desselben Feldeffekttransistors darstellt, den Eingang (30) der Schutzschaltung bildet, der mit dem Substratvorspannungsanschluß des Substrats angeschlossen ist, daß ein Gateanschluß des dritten Feldeffekttransistors (T5) mit Massepotential (V_{SS}) belegt ist, daß bei einer am Substratvorspannungsanschluß abgegriffenen Spannung, die größer als die Differenz aus dem Massepotential (V_{SS}) und der Einsatzspannung U_{T} des dritten Feldeffekttransistors ist, die zweite Kondensatorfläche (26) und der Vorspannungsgenerator (28) für den Kondensator durch die elektronische Schutzschaltung (27) getrennt sind und daß bei einer am Substratvorspannungsanschluß (18) abgegriffenen Spannung, die kleiner als die obengenannte Differenz ist, die zweite Kondensatorfläche (26) und der Vorspannungsgenerator (28) für den Kondensator durch die elektronische Schutzschaltung (27) miteinander verbunden sind.

2. Integrierte Schaltung nach Anspruch 1, **dadurch gekennzeichnet,** daß die elektronische Schutzschaltung einen vierten p-Kanal Feldeffekttransistor (T7) enthält und ein Gate-Anschluß des vierten p-Kanal Feldeffekttransistors (T7) mit einem Verbindungspunkt (39) des dritten Feldeffekttransistors (T5) und des Lastelements der Serienschaltung verbunden ist, daß ein Substratanschluß des vierten Feldeffekttransistors (T7) mit einer positiven Spannung (V_{DD}) verschaltet ist, daß ein Drain-Anschluß des vierten Feldeffekttransistors (T7) mit der zweiten Kodensatorfläche (26) und ein Source-Anschluß des vierten Feldeffekttransistors (T7) mit dem Vorspannungsgenerator (28) für den Kondensator verbunden ist.

3. Integrierte Schaltung nach Anspruch 1, **dadurch gekennzeichnet,** daß die elektronische Schutzschaltung einen vierten n-Kanal Feldeffekttransistor (T8) mit vorgeschaltetem Inverter (I) enthält, daß ein Eingang des Inverters (I) mit einem Verbindungspunkt (39) des dritten Feldeffekttransistors (T5) und des Lastelements der Serienschaltung, ein Ausgang des Inverters (I) mit einem Gate-Anschluß des vierten n-Kanal Feldeffekttransistors (T8) und ein Substratanschluß des vierten n-Kanal Feldeffekttransistors (T8) mit einer negativen Spannung (V_{BB}) verbunden ist, daß ein Sourceanschluß des vierten n-Kanal Feldeffekttransistors (T8) mit der zweiten Kondensatorfläche (26) und ein Drainanschluß desselben mit dem Vorspannungsgenerator (28) für den Kondensator verbunden ist.

4. Integrierte Schaltung nach einem der Ansprüche 1 bis 3, **dadurch gekennzeichnet,** daß das Lastelement durch einen fünften Feldeffekttransistor (T6) anderen Kanaltyps als der dritte Feldeffekttransistor (T5) realisiert ist, daß ein Gate-Anschluß des Feldeffekttransistors (T6) mit dem Gate-Anschluß des dritten Feldeffekttransistors (T5) und ein Substratanschluß des fünften Feldeffekttransistors (T6) mit einer positiven Spannung (V_{DD}) verbunden ist.

5. Integrierte Schaltung nach einem der Ansprüche 1 bis 3, **dadurch gekennzeichnet,** daß das Lastelement ein Kondensator ist.

6. Integrierte Schaltung nach Anspruch 5, **dadurch gekennzeichnet,** daß die Kapazität durch einen sechsten Feldeffekttransistor (T9) anderen Kanaltyps als der dritte Feldeffekttransistor (T5) realisiert ist, daß ein Source-, Drain- und ein Substratanschluß des sechsten Feldeffekttransistors (T9) mit einer positiven Spannung (Versorgungsspannung V_{DD}) beschaltet ist.

7. Integrierte Schaltung nach Anspruch 2, **dadurch gekennzeichnet,** daß das Lastelement ein Kondensator ist, dessen Kapazität durch eine Nutzung einer Gatekapazität des vierten Feldeffekttransistors (T7) realisiert wird.

8. Integrierte Schaltung nach einem der Ansprüche 1 bis 7, **dadurch gekennzeichnet,** daß der Ausgang (17) des Substratvorspannungsgenerators (16) über einen zusätzlichen n-Kanal Feldeffekttransistor (T4) mit einem auf Massepotential (V_{SS}) liegenden Schaltungspunkt (36) verbunden ist und daß der zusätzliche Feldeffekttransistor (T4) über eine am Substratvorspannungsanschluß (18) abgegriffene Spannung angesteuert wird.

9. Integrierte Schaltung nach Anspruch 8, **dadurch gekennzeichnet,** daß der Substratvorspannungsgenerator (16), der Vorspannungsgenerator (28) für den Kondensator, die elektronische Schutzschaltung (27) und der zusätzliche Feldeffekttransistor (T4) auf dem Halbleitersubstrat mit aufintegriert sind.

10. Integrierte Schaltung in komplementärer Schaltungstechnik mit Feldeffekttransistoren (T1, T2) unterschiedlicher Kanaltypen, von denen wenigstens ein erster (T1) in einem n-leitenden Halbleitersubstrat (1) und wenigstens ein zweiter (T2) in einer im Halbleitersubstrat vorgesehenen p-leitenden wannenförmigen Halbleiterzone (2) angeordnet sind, wobei das Halbleitersubstrat (1) mit einer positiven Versorgungsspannung (V_{DD}) beschaltet ist, wobei ein Anschlußgebiet (3) wenigstens eines ersten Feldeffekttransistors (T1) mit einem Massepotential (V_{SS}) angeschlossen ist, wobei die wannenförmige Halbleiterzone (2) über einen Substratvorspannungsanschluß (18) mit dem Ausgang 17 eines eine negative Substratvorspannung erzeugenden Substratvorspannungsgenerators (16) verbunden ist, dem das Massepotential und die Versorgungsspannung zugeführt werden, **dadurch gekennzeichnet,** daß ein Kondensator (C) mit zwei Kondensatorflächen (24, 26) vorgesehen ist, dessen erste Kondensatorfläche (24) in die wannenförmige Halbleiterzone (2) integriert ist und dessen zweite Kondensatorfläche (26) über eine elektronische Schutzschaltung (27) an einen Vorspannungsgenerator (28) für den Kondensator geschaltet wird, daß die Schutzschaltung eine Serienschaltung eines Lastelements und eines dritten, n-Kanal Feldeffekttransistors (T5) enthält, daß ein erster Anschluß dieser Serienschaltung, der zugleich einen Anschluß des Lastelements darstellt, mit der Versorgungsspannung (V_{DD}) beschaltet ist, daß der zweite Anschluß dieser Serienschaltung, der zugleich einen Anschluß des dritten Feldeffekttransistors (T5) und einen Substratanschluß desselben Feldeffekttransistors darstellt, den Eingang (30) der Schutzschaltung bildet, der mit dem Substratvorspannungsanschluß des Substrats angeschlossen ist, daß ein Gateanschluß des dritten Feldeffekttransistors (T5) mit Massepotential (V_{SS}) belegt ist, daß bei einer am Substratvorspannungsanschluß abgegriffenen Spannung, die größer als die Differenz aus dem Massepotential (V_{SS}) und der Einsatzspannung U_{T} des dritten Feldeffekttransistors ist, die zweite Kondensatorfläche (26) und der Vorspannungsgenerator (28) für den Kondensator durch die elektronische Schutzschaltung (27) getrennt sind und daß bei einer am Substratvorspannungsanschluß (18) abgegriffenen Spannung, die kleiner als die obengenannte Differenz ist, die zweite Kondensatorfläche (26) und der Vorspannungsgenerator (28) für den Kondensator durch die elektronische Schutzschaltung (27) miteinander verbunden sind.

11. Integrierte Schaltung nach Anspruch 10, **dadurch gekennzeichnet,** daß die elektronische Schutzschaltung einen vierten p-Kanal Feldeffekttransistor (T7) enthält und ein Gate-Anschluß des p-Kanal-Feldeffekttransistors (T7) mit einem Verbindungspunkt (39) des dritten Feldeffekttransistors (T5) und des Lastelements der Serienschaltung verbunden ist, daß ein Substratanschluß des vierten Feldeffekttransistors (T7) mit einer positiven Spannung (V_{DD}) verschaltet ist, daß ein Drain-Anschluß des vierten Feldeffekttransistors (T7) mit der zweiten Kodensatorfläche (26) und ein Source-Anschluß des vierten Feldeffekttransistors (T7) mit dem Vorspannungsgenerator (28) für den Kondensator verbunden ist.

12. Integrierte Schaltung nach Anspruch 10, **dadurch gekennzeichnet,** daß die elektronische Schutzschaltung einen vierten n-Kanal Feldeffekttransistor (T8) mit vorgeschaltetem Inverter (I) enthält, daß ein Eingang des Inverters (I) mit einem Verbindungspunkt (39) des dritten Feldeffekttransistors (T5) und des Lastelements der Serienschaltung, ein Ausgang des Inverters (I) mit einem Gate-Anschluß des vierten n-Kanal Feldeffekttransistors (T8) und ein Substratanschluß des vierten n-Kanal Feldeffekttransistors (T8) mit einer negativen Spannung (V_{BB}) verbunden ist, daß ein Sourceanschluß des vierten n-Kanal Feldeffekttransistors (T8) mit der zweiten Kondensatorfläche (26) und ein Drainanschluß desselben mit dem Vorspannungsgenerator (28) für den Kondensator verbunden ist.

13. Integrierte Schaltung nach einem der Ansprüche 10 bis 12, **dadurch gekennzeichnet,** daß das Lastelement durch einen fünften Feldeffekttransistor (T6) anderen Kanaltyps als der dritte Feldeffekttransistor (T5) realisiert ist, daß ein Gate-Anschluß des fünften Feldeffekttransistors (T6) mit dem Gate-Anschluß des dritten Feldeffekttransistors (T5) und ein Substratanschluß des fünften Feldeffekttransistors (T6) mit einer positiven Spannung (V_{DD}) verbunden ist.

14. Integrierte Schaltung nach einem der Ansprüche 10 bis 12, **dadurch gekennzeichnet,** daß das Lastelement ein Kondensator ist.

15. Integrierte Schaltung nach Anspruch 14, **dadurch gekennzeichnet,** daß die Kapazität durch einen sechsten Feldeffekttransistor (T9) anderen Kanaltyps als der dritte Feldeffekttransistor (T5) realisiert ist, daß ein Source-, Drain- und ein Substratanschluß des sechsten Feldeffekttransistors (T9) mit einer positiven Spannung (Versorgungsspannung V_{DD}) beschaltet ist.

16. Integrierte Schaltung nach Anspruch 11, **dadurch gekennzeichnet,** daß das Lastelement ein Kondensator ist, dessen Kapazität durch eine Nutzung einer Gatekapazität des vierten Feldeffekttransistors (T7) realisiert wird.

17. Integrierte Schaltung nach einem der Ansprüche 10 bis 16, **dadurch gekennzeichnet,** daß der Ausgang (17) des Substratvorspannungsgenerators (16) über einen zusätzlichen n-Kanal Feldeffekttransistor (T4) mit einem auf Massepotential (V_{SS}) liegenden Schaltungspunkt (36) verbunden ist und daß der zusätzliche Feldeffekttransistor (T4) über eine am Substratvorspannungsanschluß (18) abgegriffene Spannung angesteuert wird.

18. Integrierte Schaltung nach Anspruch 17, **dadurch gekennzeichnet,** daß der Substratvorspannungsgenerator (16), der Vorspannungsgenerator (28) für den Kondensator, die elektronische Schutzschaltung (27) und der zusätzliche Feldeffekttransistor (T4) auf dem Halbleitersubstrat mit aufintegriert sind.

19. Integrierte Schaltung nach einem der vorhergehenden Ansprüche, **gekennzeichnet durch** die Anwendung als Peripherieschaltung für dynamische Halbleiterspeicher hoher Integrationsdichte.

## Claims

1. Integrated circuit using complementary circuit technology and comprising field-effect transistors (T1, T2) of different channel types, of which at least one first field-effect transistor (T1) is disposed in a p-type semiconductor substrate (1) and at least one second field-effect transistor (T2) is disposed in an n-type well-shaped semiconductor zone (2) provided in the semiconductor substrate, the semiconductor zone (2) being connected to a positive supply voltage (V_{DD}), a terminal region (3) of at least one first field-effect transistor (T1) being connected to an earth potential (V_{SS}), and the semiconductor substrate (1) being connected via a substrate bias terminal (18) to the output (17) of a substrate bias generator (16) which generates a negative substrate bias and to which the earth potential and the supply voltage are fed, characterised in that a capacitor (C) is provided with two capacitor surfaces (24, 26), its first capacitor surface (24) being integrated in the semiconductor substrate (1) and its second capacitor surface (26) being connected via an electronic protection circuit (27) to a capacitor bias generator (28), in that the protection circuit contains a series circuit of a load element and a third, n-channel field-effect transistor (T5), in that a first terminal of said series circuit, which is also a terminal of the load element, is connected to the supply voltage (V_{DD}), in that the second terminal of said series circuit, which is also a terminal of the third field-effect transistor (T5) and a substrate terminal of the same field-effect transistor, forms the input (30) of the protection circuit which is connected to the substrate bias terminal of the substrate, in that a gate terminal of the third field-effect transistor (T5) is assigned to earth potential (V_{SS}), in that, at a voltage tapped off at the substrate bias terminal and greater than the difference between the earth potential (V_{SS}) and the turn-on voltage U_{T} of the third field-effect transistor, the second capacitor surface (26) and the capacitor bias generator (28) are isolated by the electronic protection circuit (27), and in that, at a voltage tapped off at the substrate bias terminal (18) and less than the abovementioned difference, the second capacitor surface (26) and the capacitor bias generator (28) are interconnected by the electronic protection circuit (27).

2. Integrated circuit according to Claim 1, characterised in that the electronic protection circuit contains a fourth p-channel field-effect transistor (T7) and a gate terminal of the fourth p-channel field-effect transistor (T7) is connected to an interconnection point (39) of the third field-effect transistor (T5) and of the load element of the series circuit, in that a substrate terminal of the fourth field-effect transistor (T7) is connected to a positive voltage (V_{DD}), and in that a drain terminal of the fourth field-effect transistor (T7) is connected to the second capacitor surface (26) and a source terminal of the fourth field-effect transistor (T7) is connected to the capacitor bias generator (28).

3. Integrated circuit according to Claim 1, characterised in that the electronic protection circuit contains a fourth n-channel field-effect transistor (T8) with an inverter (I) connected in incoming circuit, in that an input of the inverter (I) is connected to an interconnection point (39) of the third field-effect transistor (T5) and of the load element of the series circuit, an output of the inverter (I) is connected to a gate terminal of the fourth n-channel field-effect transistor (T8) and a substrate terminal of the fourth n-channel field-effect transistor (T8) is connected to a negative voltage (V_{BB}), and in that a source terminal of the fourth n-channel field-effect transistor (T8) is connected to the second capacitor surface (26) and a drain terminal of the same is connected to the capacitor bias generator (28).

4. Integrated circuit according to one of Claims 1 to 3, characterised in that the load element is formed by a fifth field-effect transistor (T6) of a channel type other than that of the third field-effect transistor (T5), and in that a gate terminal of the field-effect transistor (T6) is connected to the gate terminal of the third field-effect transistor (T5) and a substrate terminal of the fifth field-effect transistor (T6) is connected to a positive voltage (V_{DD}).

5. Integrated circuit according to Claims 1 to 3, characterised in that the load element is a capacitor.

6. Integrated circuit according to Claim 5, characterised in that the capacitance is formed by a sixth field-effect transistor (T9) of a channel type other than that of the third field-effect transistor (T5), and in that a source terminal, drain terminal and a substrate terminal of the sixth field-effect transistor (T9) are connected to a positive voltage (supply voltage V_{DD}).

7. Integrated circuit according to Claim 2, characterised in that the load element is a capacitor whose capacitance is formed by utilising a gate capacitance of the fourth field-effect transistor (T7).

8. Integrated circuit according to one of Claims 1 to 7, characterised in that the output (17) of the substrate bias generator (16) is connected via an additional n-channel field-effect transistor (T4) to a circuit point (36) which is at earth potential (V_{SS}), and in that the additional field-effect transistor (T4) is triggered by means of a voltage tapped off at the substrate bias terminal (18).

9. Integrated circuit according to Claim 8, characterised in that the substrate bias generator (16) the capacitor bias generator (28), the electronic protection circuit (27) and the additional field-effect transistor (T4) are conjointly integrated on the semiconductor substrate.

10. Integrated circuit using complementary circuit technology and comprising field-effect transistors (T1, T2) of different channel types, of which at least one first field-effect transistor (T1) is disposed in an n-type semiconductor substrate (1) and at least one second field-effect transistor (T2) is disposed in a p-type well-shaped semiconductor zone (2) provided in the semiconductor substrate, the semiconductor substrate (1) being connected to a positive supply voltage (V_{DD}), a terminal region (3) of at least one first field-effect transistor (T1) being connected to an earth potential (V_{SS}), and the well-shaped semiconductor zone (2) being connected via a substrate bias terminal (18) to the output (17) of a substrate bias generator (16) which generates a negative substrate bias and to which the earth potential and the supply voltage are fed, characterised in that a capacitor (C) is provided with two capacitor surfaces (24, 26), its first capacitor surface (24) being integrated in the well-shaped semiconductor zone (2) and its second capacitor surface (26) being connected via an electronic protection circuit (27) to a capacitor bias generator (28), in that the protection circuit contains a series circuit of a load element and a third, n-channel field-effect transistor (T5), in that a first terminal of said series circuit, which is also a terminal of the load element, is connected to the supply voltage (V_{DD}), in that the second terminal of said series circuit, which is also a terminal of the third field-effect transistor (T5) and a substrate terminal of the same field-effect transistor, forms the input (30) of the protection circuit which is connected to the substrate bias terminal of the substrate, in that a gate terminal of the third field-effect transistor (T5) is assigned to earth potential (V_{SS}), in that, at a voltage tapped off at the substrate bias terminal and greater than the difference between the earth potential (V_{SS}) and the turn-on voltage U_{T} of the third field-effect transistor, the second capacitor surface (26) and the capacitor bias generator (28) are isolated by the electronic protection circuit (27), and in that, at a voltage tapped off at the substrate bias terminal (18) and less than the above-mentioned difference, the second capacitor surface (26) and the capacitor bias generator (28) are interconnected by the electronic protection circuit (27).

11. Integrated circuit according to Claim 10, characterised in that the electronic protection circuit contains a fourth p-channel field-effect transistor (T7) and a gate terminal of the p-channel field-effect transistor (T7) is connected to an interconnection point (39) of the third field-effect transistor (T5) and the load element of the series circuit, and in that a substrate terminal of the fourth field-effect transistor (T7) is connected to a positive voltage (V_{DD}), and in that a drain terminal of the fourth-field transistor (T7) is connected to the second capacitor surface (26) and a source terminal of the fourth field-effect transistor (T7) is connected to the capacitor bias generator (28).

12. Integrated circuit according to Claim 10, characterised in that the electronic protection circuit contains a fourth n-channel field-effect transistor (T8) with an inverter (I) connected in incoming circuit, in that an input of the inverter (I) is connected to an interconnection point (39) of the third field-effect transistor (T5) and of the load element of the series circuit, an output of the inverter (I) is connected to a gate terminal of the fourth n-channel field-effect transistor (T8) and a substrate terminal of the fourth n-channel field-effect transistor (T8) is connected to a negative voltage (V_{BB}), and in that a source terminal of the fourth n-channel field-effect transistor (T8) is connected to the second capacitor surface (26) and a drain terminal of the same is connected to the capacitor bias generator (28).

13. Integrated circuit according to one of Claims 10 to 12, characterised in that the load element is formed by a fifth field-effect transistor (T6) of a channel type other than that of the third field-effect transistor (T5), and in that a gate terminal of the fifth field-effect transistor (T6) is connected to the gate terminal of the third field-effect transistor (T5) and a substrate terminal of the fifth field-effect transistor (T6) is connected to a positive voltage (V_{DD}).

14. Integrated circuit according to one of Claims 10 to 12, characterised in that the load element is a capacitor.

15. Integrated circuit according to Claim 14, characterised in that the capacitance is formed by a sixth field-effect transistor (T9) of a channel type other than that of the third field-effect transistor (T5), and in that a source, drain and a substrate terminal of the sixth field-effect transistor (T9) are connected to a positive voltage (supply voltage V_{DD}).

16. Integrated circuit according to Claim 11, characterised in that the load element is a capacitor whose capacitance is formed by utilising a gate capacitance of the fourth field-effect transistor (T7).

17. Integrated circuit according to one of Claims 10 to 16, characterised in that the output (17) of the substrate bias generator (16) is connected via an additional n-channel field-effect transistor (T4) to a circuit point (36) which is at earth potential (V_{SS}), and in that the additional field-effect transistor (T4) is triggered by means of a voltage tapped off at the substrate bias terminal (18).

18. Integrated circuit according to Claim 17, characterised in that the substrate bias generator (16), the capacitor bias generator (28), the electronic protection circuit (27) and the additional field-effect transistor (T4) are conjointly integrated on the semiconductor substrate.

19. Integrated circuit according to one of the preceding claims, characterised by the application as peripheral circuit for dynamic semiconductor memories with high integration density.

## Revendications

1. Circuit intégré en technologie de circuit complémentaire comportant des transistors à effet de champ (T1, T2) de types de canal différents, parmi lesquel au moins un premier transistor à effet de champ (T1) est disposé dans un substrat à semiconducteur (1) de conductivité p et au moins un deuxième transistor à effet de champ (T2) est disposé dans une zone à semiconducteur (2) en forme de cuvette de conductivité n, prévue dans le substrat à semiconducteur, du type dans lequel la zone à semiconducteur (2) est portée à une tension d'alimentation (V_{DD}) positive, une zone de connexion (3) au moins d'un premier transistor à effet de champs (T1) est connectée à un potentiel de masse (V_{SS}), le substrat à semiconducteur (1) est relié par l'intermédiaire d'une borne (18) de la tension de polarisation du substrat à la sortie (17) d'un générateur (16) de tension de polarisation du substrat, qui crée une tension négative de polarisation du substrat et auquel sont envoyés le potentiel de masse et la tension d'alimentation, caractérisé en ce qu'il est prévu un condensateur (C) comportant deux faces (24, 26) de condensateur, dont la première face (24) de condensateur est intégrée dans le substrat à semiconducteur (1) et dont la seconde face (26) de condensateur est connectée, par l'intermédiaire d'un circuit électronique de protection (27), à un générateur (28) de tension de polarisation pour le condensateur, en ce que le circuit de protection comprend un circuit série d'un élément de charge et d'un troisième transistor à effet de champ (T5) à canal n, en ce qu'une première borne de ce circuit série, qui représente en même temps une borne de l'élément de charge, est reliée à la tension d'alimentation (V_{DD}), en ce que la deuxième borne de ce circuit série, qui représente en même temps une borne du troisième transistor à effet de champ (T5) et une borne de substrat de ce même transistor à effet de champ, forme l'entrée (30) du circuit de protection, qui est connectée à la borne de la tension de polarisation du substrat, en ce qu'une borne de grille du troisième transistor à effet de champ (T5) est mise au potentiel de masse (V_{SS}), en ce que, pour une tension prélevée à la borne de la tension de polarisation du substrat, qui est supérieure à la différence du potentiel de masse (V_{SS}) et de la tension de coupure U_{T} du troisième transistor à effet de champ, la seconde face (26) du condensateur et le générateur (28) de tension de polarisation pour le condensateur sont déconnectés l'un de l'autre par l'intermédiaire du circuit électronique de protection (27), et en ce que pour une tension prélevée à la borne (18) de la tension de polarisation du substrat, qui est inférieure à la différence précédemment citée, la seconde face (26) du condensateur et le générateur (28) de tension de polarisation pour le condensateur sont reliés ensemble par l'intermédiaire du circuit électronique de protection (27).

2. Circuit intégré selon la revendication 1, caractérisé en ce que le circuit électronique de protection comprend un quatrième transistor à effet de champ (T7) à canal p et une borne de grille du quatrième transistor à effet de champ (T7) à canal p est reliée à un point de connexion (39) du troisième transistor à effet de champ (T5) et de l'élément de charge du circuit série, en ce qu'une borne de substrat du quatrième transistor à effet de champ (T7) est connectée à une tension (V_{DD}) positive, en ce qu'une borne de drain du quatrième transistor à effet de champ (T7) est reliée à la seconde face (26) du condensateur et une borne de source du quatrième transistor à effet de champ (T7) est reliée au générateur (28) de tension de polarisation pour le condensateur.

3. Circuit intégré selon la revendication 1, caractérisé en ce que le circuit électronique de protection comprend un quatrième transistor à effet de champ (T8) à canal n, à inverseur amont (I), en ce qu'une entrée de l'inverseur (I) est reliée à un point de connexion (39) du troisième transistor à effet de champ (T5) et de l'élément de charge du circuit série, une sortie de l'inverseur (I) est reliée à une borne de grille du quatrième transistor à effet de champ (T8) à canal n et une borne de substrat du quatrième transistor à effet de champ (T8) à canal n est portée à une tension (V_{BB}) négative, en ce qu'une borne de source du quatrième transistor à effet de champ (T8) à canal n est reliée à la seconde face (26) du condensateur et une borne de drain pour ce même transistor à effet de champ est reliée au générateur (28) de tension de polarisation pour le condensateur.

4. Circuit intégré selon l'une des revendications 1 à 3, caractérisé en ce que, l'élément de charge est réalisé au moyen d'un cinquième transistor à effet de champ (T6) d'un autre type de canal que celui du troisième transistor à effet de champ (T5), en ce qu'une borne de grille du transistor à effet de champ (T6) est reliée à une borne de grille du troisième transistor à effet de champ (T5) et une borne de substrat du cinquième transistor à effet de champ (T6) est reliée à une tension (V_{DD}) positive.

5. Circuit intégré selon l'une des revendications 1 à 3, caractérisé en ce que l'élément de charge est un condensateur.

6. Circuit intégré selon la revendication 5, caractérisé en ce que la capacité est réalisée au moyen d'un sixième transistor à effet de champ (T9) d'un autre type de canal que celui du troisième transistor à effet de champ (T5), en ce qu'une borne de source, de drain et une borne de substrat du sixième transistor à effet de champ (T9) sont connectées à une tension positive (tension d'alimentation V_{DD}).

7. Circuit intégré selon la revendication 2, caractérisé en ce que l'élément de charge est un condensateur dont la capacité est réalisée par utilisation d'une capacité de grille du quatrième transistor à effet de champ (T7).

8. Circuit intégré selon l'une des revendications 1 à 7, caractérisé en ce que la sortie (17) du générateur (16) de la tension de polarisation du substrat est reliée, par l'intermédiaire d'un transistor à effet de champ supplémentaire (T4) à canal n, à un point du câblage (36) placé au potentiel de masse (V_{SS}), et en ce que le transistor à effet de champ supplémentaire (T4) est commandé par une tension prélevée à la borne (18) de la tension de polarisation du substrat.

9. Circuit intégré selon la revendication 8, caractérisé en ce que le générateur (16) de tension de polarisation du substrat, le générateur (28) de tension de polarisation pour le condensateur, le circuit électronique de protection (27) et le transistor à effet de champ supplémentaire (T4) sont intégrés dans le substrat à semiconducteur.

10. Circuit intégré en technologie de circuit complémentaire comportant des transistors à effet de champ (T1, T2) de types de canal différents, parmi lesquels au moins un premier transistor à effet de champ (T1) est disposé dans le substrat à semiconducteur (1) de conductivité n et au moins un second transistor à effet de champ (T2) est disposé dans la zone à semiconducteur (2) en forme de cuvette de conductivité p, prévue dans le substrat à semiconducteur, du type dans lequel le substrat à semiconducteur (1) est porté à une tension d'alimentation (V_{DD}) positive, une zone de connexion (3) au moins d'un premier transistor à effet de champ (T1) est connectée à un potentiel de masse (V_{SS}), la zone (2) à semiconducteur en forme de cuvette est reliée, par l'intermédiaire d'une borne (18) de la tension de polarisation du substrat, à la sortie (17) d'un générateur (16) de tension de polarisation du substrat, qui crée une tension négative de polarisation du substrat et auquel sont envoyés le potentiel de masse et la tension d'alimentation, caractérisé en ce qu'il est prévu un condensateur (C) comportant deux faces (24, 26) de condensateur, dont la première face (24) de condensateur est intégrée dans la zone à semiconducteur (2) en forme de cuvette et dont la seconde face (26) de condensateur est connectée, par l'intermédiaire d'un circuit électronique de protection (27), à un générateur (28) de tension de polarisation pour le condensateur, en ce que le circuit de protection comprend un circuit série d'un élément de charge et d'un troisième transistor à effet de champ (T5) à canal n, en ce qu'une première borne de ce circuit série, qui représente en même temps une borne de l'élément de charge, est reliée à la tension d'alimentation (V_{DD}), en ce que la deuxième borne de ce circuit série, qui représente en même temps une borne du troisième transistor à effet de champ (T5) et une borne de substrat de ce même transistor à effet de champ, forme l'entrée (30) du circuit de protection, qui est connectée à la borne de la tension de polarisation du substrat, en ce qu'une borne de grille du troisième transistor à effet de champ (T5) est mise au potentiel de masse (V_{SS}), en ce que, pour une tension prélevée à la borne de la tension de polarisation du substrat qui est supérieure à la différence du potentiel de masse (V_{SS}) et de la tension de coupure U_{T} du troisième transistor à effet de champ, la seconde face (26) du condensateur et le générateur (28) de tension de polarisation pour le condensateur sont déconnectés l'un de l'autre par l'intermédiaire du circuit électronique de protection (27), et en ce que, pour une tension prélevée à la borne (18) de la tension de polarisation du substrat qui est inférieure à la différence précédemment citée, la seconde face (26) du condensateur et le générateur (28) de tension de polarisation pour le condensateur sont reliés ensemble par l'intermédiaire du circuit électronique de protection (27).

11. Circuit intégré selon la revendication 10, caractérisé en ce que le circuit électronique de protection comprend un quatrième transistor à effet de champ (T7) à canal p et une borne de grille du transistor à effet de champ (T7) à canal p est reliée à un point de connexion (39) du troisième transistor à effet de champ (T5) et de l'élément de charge du circuit série, en ce qu'une borne de substrat du quatrième transistor à effet de champ (T7) est connectée à une tension (V_{DD}) positive, en ce qu'une borne de drain du quatrième transistor à effet de champ (T7) est reliée à la seconde face (26) du condensateur et une borne de source du quatrième transistor à effet de champ (T7) est reliée au générateur (28) de tension de polarisation pour le condensateur.

12. Circuit intégré selon la revendication 10, caractérisé en ce que le circuit électronique de protection comprend un quatrième transistor à effet de champ (T8) à canal n à inverseur amont (I), en ce qu'une entrée de l'inverseur (I) est reliée à un point de connexion (39) du troisième transistor à effet de champ (T5) et de l'élément de charge du circuit série, une sortie de l'inverseur (I) est reliée à une borne de grille du quatrième transistor à effet de champ (T8) à canal n et une borne de substrat du quatrième transistor à effet de champ (T8) à canal n est reliée à une tension (V_{BB}) négative, en ce qu'une borne de source du quatrième transistor à effet de champ (T8) à canal n est reliée à la seconde face (26) du condensateur et une borne de drain de ce même transistor à effet de champ est reliée au générateur (28) de tension de polarisation pour le condensateur.

13. Circuit intégré selon l'une quelconque des revendications 10 à 12, caractérisé en ce que l'élément de charge est réalisé au moyen d'un cinquième transistor à effet de champ (T6) d'un autre type de canal que celui du troisième transistor à effet de champ (T5), en ce qu'une borne de grille du cinquième transistor à effet de champ (T6) est reliée à une borne de grille du troisième transistor à effet de champ (T5) et une borne de substrat du cinquième transistor à effet de champ (T6) est reliée à une tension (V_{DD}) positive.

14. Circuit intégré selon l'une quelconque des revendications 10 à 12, caractérisé en ce que l'élément de charge est un condensateur.

15. Circuit intégré selon la revendication 14, caractérisé en ce que la capacité est réalisée au moyen d'un sixième transistor à effet de champ (T9) d'un autre type de canal que celui du troisième transistor à effet de champ (T5), en ce qu'une borne de source, de drain et une borne de substrat du sixième transistor à effet de champ (T9) sont connectée à une tension positive (tension de polarisation V_{DD}).

16. Circuit intégré selon la revendication 11, caractérisé en ce que l'élément de charge est un condensateur, dont la capacité est réalisée en utilisant une capacité de grille du quatrième transistor à effet de champ (T7).

17. Circuit intégré selon l'une des revendications 10 à 16, caractérisé en ce que la sortie (17) du générateur (16) de tension de polarisation du substrat est reliée, par l'intermédiaire d'un transistor à effet de champ supplémentaire (T4) à canal n, à un point de câblage (36) placé au potentiel de masse (V_{SS}), et en ce que le transistor à effet de champ supplémentaire (T4) est commandé par une tension prélevée à la borne (18) de la tension de polarisation du substrat.

18. Circuit intégré selon la revendication 17, caractérisé en ce que le générateur (16) de tension de polarisation du substrat, le générateur (28) de tension de polarisation pour le condensateur, le circuit électronique de protection (27) et le transistor à effet de champ supplémentaire (T4) sont intégrés dans le substrat à semiconducteur.

19. Circuit intégré selon l'une des revendications précédentes, caractérisé en ce qu'il est utilisé comme circuit périphérique pour des mémoires dynamiques à semiconducteurs à grande densité d'intégration.
